(19) Europäisches Patentamt

European Patent Office

Office européen des brevets

(11) **EP 4 557 611 A1**

(12) **EUROPEAN PATENT APPLICATION**

(43) Date of publication:
**21.05.2025 Bulletin 2025/21**

(21) Application number: **23210737.5**

(22) Date of filing: **17.11.2023**

(51) International Patent Classification (IPC):
**H03F 1/22** *(2006.01)* **H03F 1/56** *(2006.01)*
**H03F 3/195** *(2006.01)*

(52) Cooperative Patent Classification (CPC):
**H03F 1/223; H03F 1/565; H03F 3/195;**
H03F 2200/294; H03F 2200/451; H03F 2200/541

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Stichting IMEC Nederland
5656 AE Eindhoven (NL)**

(72) Inventors:
• **BHAT, Anoop
5508 VD Veldhoven (NL)**
• **MATEMAN, Paul
6566 ER Millingen a/d Rijn (NL)**

(74) Representative: **IP HILLS NV
Bellevue 5/501
9050 Gent-Ledeberg (BE)**

(54) **LOW-NOISE AMPLIFIER**

(57) A low-noise amplifier, LNA, circuitry for amplifying an input signal to an output signal; the circuitry comprising a first cascode amplifier and a second complementary cascode amplifier, respectively connected to a first load and a second load; wherein the first load and the second load are coupled and wherein the output signal is an output of the first or second cascode amplifier; wherein the first cascode amplifier comprises a first initial amplification stage and a first transistor; wherein the second cascode amplifier comprises a second initial amplification stage, and a second transistor, arranged in a common-gate configuration, in cascode with the second initial amplification stage and connected to the second load; and wherein inputs of the first and second transistors are capacitively coupled such that the first and second transistors are connected at frequencies higher than a frequency characterising the capacitive coupling.

Fig. 1

**EP 4 557 611 A1**

## Description

### Technical Field

The present invention generally relates to a low-noise amplifier, LNA, circuitry.

### Background

Low-noise amplifier, LNA, circuitries provide amplification while minimising additional noise introduced during amplification. They process noisy signals, often having a low amplitude, with minimal further noise contributions to the signal. Applications comprise amplifying wireless incoming signals captured by a receiver antenna, for example, in radio frequency integrated circuits, RFIC.

Low-noise amplifiers may be implemented in complementary metal oxide semiconductor, CMOS, technology, for achieving a low power consumption. As CMOS evolves to smaller transistor sizes and lower supply voltages, it may become a challenge to provide low-noise amplifiers while maintaining required biasing and linearity of transistors.

It is an object of the invention to provide a low-noise amplifier circuitry that alleviates one or more of the abovementioned obstacles.

### Summary

According to some aspects, there is provided the subject matter of the independent claim. Some further aspects are defined in the dependent claims.

According to a first example aspect, the object of the invention is achieved by providing a low-noise amplifier, LNA, circuitry for amplifying an input signal at an input to an output signal at an output. The circuitry comprises a first cascode amplifier and a second complementary cascode amplifier, respectively connected to a first load and a second load. The first load and the second load are coupled and the output signal is an output of the first or second cascode amplifier. The first cascode amplifier comprises a first initial amplification stage and a first transistor. The first initial amplification stage is connected to the input and to a lower power supply node. The first transistor is arranged in a common-gate configuration, in cascode with the first initial amplification stage and connected to the first load. The second cascode amplifier comprises a second initial amplification stage and a second transistor. The second initial amplification stage is connected to the input and to a higher power supply node. The second transistor is arranged in a common-gate configuration, in cascode with the second initial amplification stage and connected to the second load. Further, inputs of the first and second transistors are capacitively coupled such that the first and second transistors are connected at frequencies higher than a frequency characterising the capacitive coupling.

The first cascode amplifier and the second cascode amplifier are arranged as two complementary sub-circuitries that are coupled via their respective end loads in order to provide a single output. The capacitive coupling provides a direct link between internal nodes of the first and second cascode amplifiers. In particular, the capacitive coupling provides a short circuit for alternating current, AC, and an open circuit for direct current, DC, between the inputs of the first transistor and of the second transistor. Thus, the LNA circuitry behaves the same in DC as it would without the capacitive coupling, yet provides an additional interconnection between internal nodes of the first and second cascode amplifiers for AC signals.

The common-gate configuration provides small input impedance, which is desirable for LNA circuitries to achieve wide bandwidth. Furthermore, a complementary set-up is beneficial for reducing distortion, or, in other words, non-linearity due to the symmetry it introduces into the circuitry. By providing complementary paths, higher order harmonics of signals may be cancelled out. On the other hand, stacking transistors requires an increased supply voltage in order to enable biasing of the transistors in the proper operating region. By directing the complementary cascode amplifiers along separate paths, stacking of threshold voltages is avoided thereby keeping the required supply voltage low. To provide a single output, the cascode amplifier branches are combined via an indirect coupling of the first and second loads, while preserving the lower necessary voltage supply. This way, linearity benefits resulting from symmetry still occur, even though the symmetry may no longer be ideally present by separating the cascode amplifier branches. In addition, biasing is an issue due to an evolution of electronics technology towards lower power consumption and therefore lower power supplies. Circuitries may be supplied with increasingly lower DC voltages. By providing the two separate branches without stacking the transistors, the challenge of operating at a low DC voltage may be overcome.

The DC-problem, i.e. the biasing problem, and the AC-problem of non-linearity are two crucial issues for LNA circuitries. By providing the capacitive coupling between the inputs of the first transistor and of the second transistor, both issues are addressed. Since the capacitive coupling functions as an open circuit in DC, the separate cascode amplifier branches remain separate in DC, resulting in a low necessary voltage supply. In AC, the capacitive coupling functions as a short circuit, resulting in a cancelling of distortion components, due to symmetry of the circuit branches in AC, and greatly improving linearity of the LNA circuitry. Thus, introducing the capacitive coupling ensures keeping a low required bias and power supply while removing non-linear effects such as intermodulation distortion or harmonic distortion.

According to an embodiment, the first and second transistors are configured to operate in a strong saturation region.

Transistors may exhibit a different behaviour depending on its biasing, i.e. the DC voltage supplied across the different terminals of the transistor. These different dependencies between transistor parameters are described by defining regions in transistor characteristics curves, such that the behaviour in a region can be captured by a single equation. In the strong saturation region, the current flowing through a transistor is linearly depending on a biasing voltage, e.g. a voltage between the drain terminal and the source terminal of a metal oxide semiconductor field effect transistor, MOSFET. The linear dependence in the strong saturation region has a relatively small slope, i.e. significantly smaller than in the ohmic region, sometimes also referred to as the linear region or triode mode. The strong saturation region may also be referred to as saturation region or active region.

By biasing the first transistor and the second transistor in the strong saturation region, a stable and correct functioning of the LNA circuitry is ensured.

According to further embodiments, the first and second transistors respectively comprise a first gate terminal and a second gate terminal; the first gate terminal is connected to the higher power supply; and the second gate terminal is connected to the lower power supply.

For example, the first transistor may be an N-channel metal oxide semiconductor, NMOS, transistor and the second transistor may be a P-channel metal oxide semiconductor, PMOS, transistor. By connecting the gate terminals to the power supply, the first transistor and the second transistor are arranged in a common-gate configuration.

According to an example embodiment, the first and second initial amplification stages each comprise a transistor, arranged in a common-source configuration.

A transistor arranged in a common-source configuration provides a relatively high gain in comparison to other topologies. As such, the first initial amplification stage and the second initial amplification stage may provide an effective initial amplification of the input signal, before passing the signal to the first transistor and the second transistor respectively. For LNA applications, it may be effective to provide a sufficient amplification of the input signal, as it may have a relatively small amplitude.

According to an embodiment, the LNA circuitry further comprises a first and a second pre-amplifier configured to pre-amplify the input signal and provide the so obtained pre-amplified input signal to the inputs of the first and second transistors respectively.

By providing pre-amplification of the input signal before passing through the first and second initial amplification stages, a further amplification may be achieved, which is especially useful for input signals having a small amplitude. In addition, by providing a symmetric pre-amplification to the two cascode amplifier sections, the linearising effect of the capacitive coupling is further enhanced. This linearity improvement is caused by the additional AC path provided by the capacitive coupling, connecting the pre-amplifier outputs and thereby allowing a compensation of non-linear signal components to occur.

According to further example embodiments, the first and second loads each comprise an inductive coil.

The inductive coils may be arranged compactly on an integrated circuit.

According to further example embodiments, the coils are inductively coupled, thereby coupling the first and second loads.

By inductively coupling the first load and the second load, a transformer is realised at the output. Advantageously, second order non-linear signal components on the outputs of the first and second common-gate transistors are cancelled out by the inductive coupling. Additionally, by combining the first and second loads via an indirect inductive coupling, the cascode amplifiers are kept along separate branches and are not stacked on top of each other. This ensures that the advantage of the biasing requiring only a low power supply is not compromised.

According to further example embodiments, the coils are capacitively coupled, thereby coupling the first and second loads.

By capacitively coupling the coils, the result of both cascode amplifiers is combined without comprising the separate low power DC biasing, since a capacitive coupling behaves as an open circuit in DC.

According to further example embodiments, the first and second loads each comprise a capacitor.

Applying a capacitor allows to fix a desired filtering behaviour of the first load and the second load, depending on the capacitor's capacitance.

According to further example embodiments, the first and second loads are capacitively coupled.

By capacitively coupling the first load with the second load, the result of both cascode amplifiers is combined without comprising the separate low power DC biasing, since a capacitive coupling behaves as an open circuit in DC.

According to further example embodiments, the LNA circuitry further comprises a coupling capacitor for providing the capacitive coupling.

By placing a capacitor, the capacitor's capacitance fixes the filtering behaviour of the first load and the second load, wherein the capacitance is a design parameter.

According to further example embodiments, the LNA circuitry further comprises an output amplifier, wherein the output signal is further applied to the output amplifier, thereby cascading the first and second cascode amplifiers with the output amplifier.

By further providing an output amplification stage, a useful part of the input signal may be provided for further processing. The output amplifier can be seen as an additional stage cascaded to the cascode amplifiers' output. It is noted that there is a significant difference between the term 'cascode', referring to the stacking of transistors along a configuration in series, and the term 'cascade'. 'Cascading' refers to providing subsequent sub-circuitries or stages, usually designed to perform a certain operation, wherein signals are passed from one stage to another. These stages fulfil a certain functionality and may be independent electronic building blocks.

According to an embodiment, the output amplifier comprises an output transistor, arranged in a common-source configuration and connected to an output load.

The common-source configuration is suited for providing amplification due to its inherent property of providing a high gain. By providing a single common-source connected amplifier as the output amplifier, it may be compactly realised.

According to further embodiments, the output signal is the output of the first cascode amplifier and the output transistor is an N-channel metal oxide semiconductor, NMOS, transistor.

According to further embodiments, the output signal is the output of the second cascode amplifier and the output transistor is a P-channel metal oxide semiconductor, PMOS, transistor.

Due to the structure of the LNA circuitry, either of the first and the second cascode amplifier outputs may be utilised as the output signal. Advantageously, when taking the output signal as the output of the first cascode amplifier, the resulting N-channel MOS output transistor may provide a faster operation since electrons are known to propagate faster than holes.

## Brief Description of the Drawings

Fig. 1 shows a schematic of a low-noise amplifier circuitry according to an example embodiment.

Fig. 2 shows a schematic of a low-noise amplifier circuitry according to an example embodiment wherein a first load and a second load comprise an inductancecapacitance, LC, filter being inductively coupled.

Fig. 3 shows a schematic of a low-noise amplifier circuitry according to an example embodiment, wherein a first load and a second load comprise an inductancecapacitance, LC, filter being capacitively coupled.

Fig. 4 shows a schematic of a low-noise amplifier circuitry according to an example embodiment having two pre-amplifiers.

Fig. 5 shows a schematic of a low-noise amplifier circuitry according to an example embodiment having two pre-amplifiers, each comprising a series of a capacitor and complementary transistors.

Fig. 6 shows a schematic of a low-noise amplifier circuitry according to an example embodiment comprising an output amplifier.

Fig. 7 shows a schematic of a low-noise amplifier circuitry according to an example embodiment comprising an output amplifier.

## Detailed Description of Embodiment(s)

Low-noise amplifier, LNA, circuitries may be used for amplifying signals obtained from an antenna at a receiving side, e.g. in RFIC. RFIC refers to the field of generating and processing electromagnetic waves in the radio spectrum. The radio spectrum is often referred to as including radio waves, microwaves and infrared waves and may, for example, be defined between 3 hertz, Hz, and 3 terahertz, THz or even more. Examples of radio frequency applications comprise telecommunications, radio broadcasting and satellite navigation.

In the present disclosure, a transistor is described to have a source terminal, a gate terminal, and a drain terminal, according to field-effect transistor, FET, terminology. Since the issues concerning LNA circuitries are inherently tied to lowpower signals, FET technology, e.g. complementary metal oxide semiconductor, CMOS, technology, lends itself to the purpose and may be used for LNA circuitries. Apart from FET transistors, other types of transistors may also be used, e.g. bipolar junction transistors. Using other transistor technologies, the terms 'source', 'gate' and 'drain' may be replaced by their corresponding terms, e.g., 'emitter', 'base' and 'collector' respectively in the case of bipolar junction transistors.

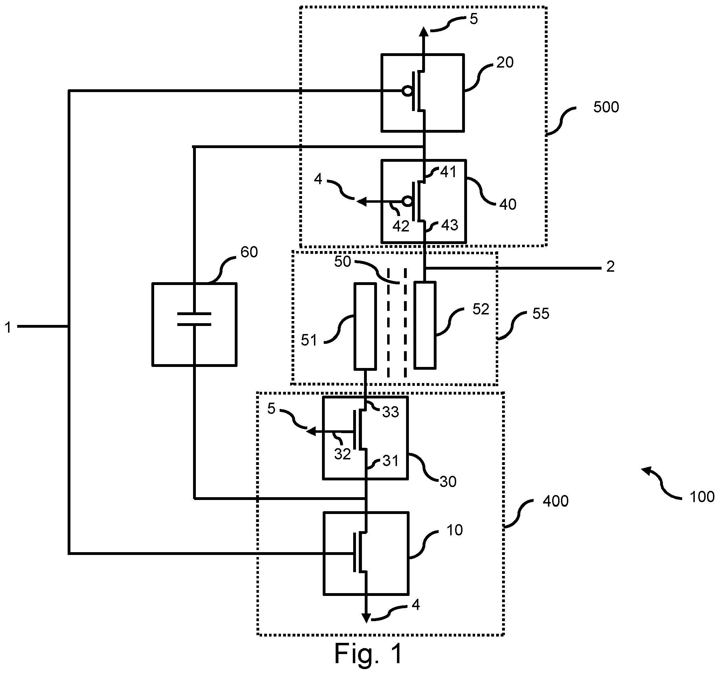

In Figure 1, a low-noise amplifier circuitry 100 according to example embodiments is schematically shown. The input connection 1 is configured to take an input signal and may, for example, be connected to an antenna. The LNA circuitry 100 comprises two cascode amplifiers 400, 500. The cascode amplifiers 400, 500 are each connected to one of two loads 51, 52, as such forming two amplifier branches: a first branch comprising the first cascode amplifier 400 and the first load 51; and a second branch comprising the second cascode amplifier 500 and the second load 52. The loads 51, 52 are combined via a coupling 50 to provide an output signal at the output connection 2, for example, for further processing of the output signal by a further circuitry. A loading sub-circuitry 55 is indicated in Figure 1, comprising the loads 51, 52 and the coupling 50 between them. The parameters of loading sub-circuitry 55, e.g. impedances of load 51 and load 52, may be dimensioned such that the LNA circuitry operates within a desired frequency range.

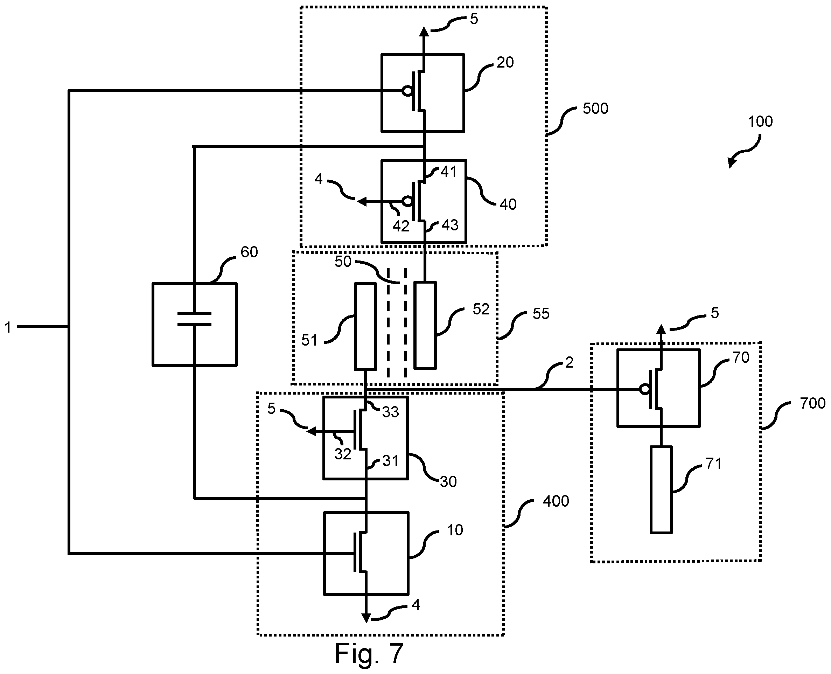

In Figure 1, the output 2 is shown to be a node of the branch of the cascode amplifier 500. Alternatively, the output signal may be a signal taken from the branch of the cascode amplifier 400, as illustrated in Figure 7.

Further, the LNA circuitry 100 comprises a capacitive coupling 60 between the inputs 31, 41 of the first and second transistors 30, 40. The LNA circuitry 100 also comprises a power supply (not shown) having two nodes or contacts: a lower power supply node and a higher power supply node, e.g. a negative and a positive node respectively. The power supply may, for example, be a voltage power supply providing a voltage difference of 0.8V.

A first cascode amplifier 400 comprises an initial amplification stage 10, which, for example, may comprise an initial transistor 10 arranged in a common-source configuration, as illustrated in Figure 1. In the term 'initial amplification stage', 'initial' refers to its direct connection to the input 1. It is the first, or, in other words, initial part of the circuitry 100 that an input signal encounters. The common-source configuration entails that the source terminal of the transistor 10 is connected to a reference node, in this case the lower power supply node 4. The initial transistor 10 provides an amplification of the input signal.

Further, the cascode amplifier 400 comprises a transistor 30. In Figure 1, the drain terminal of the common-source transistor 10 is further connected to the source terminal 31 of the transistor 30, wherein the transistor 30 is set-up in a common-gate configuration. The common-gate configuration entails that the gate terminal 32 of the transistor 30 is connected to a reference node, in this case the higher power supply node 5. The common-gate configuration enables a relatively small input or source impedance. The transistor 30 is further connected to one of the loads 51 via its drain terminal 33. The source terminal 31 of the transistor 30 may also be referred to as the input of the transistor 30. The drain terminal 33 of transistor 30 is referred to as the output of transistor 30.

Further, it is noted that the term 'cascode amplifier' refers here to an amplifier comprising at least a transistor 30 that is arranged in a common gate configuration, wherein the transistor 30 is further connected in cascode, also referred to as in series, with a further amplification stage. The further amplification stage may, for example, comprise another transistor 10, as in the example of Figure 1, or may comprise another configuration of multiple transistors.

The second cascode amplifier 500 of the other branch is complementary to the cascode amplifier 400. For example, as shown in Figure 1, the cascode amplifier 400 may comprise NMOS transistors while the cascode amplifier 500 may comprise PMOS transistors, indicated by the small circle at the gate terminal. Analogously to the cascode amplifier 400, the cascode amplifier 500 comprises transistors 20, 40. Analogously to the cascode amplifier 400, transistor 20 is connected according to the common-source configuration, wherein the source terminal of the initial transistor 20 is connected to the higher power supply 5. The gate terminal of the transistor 20 is connected to the input node 1. The input, or, in other words, the source terminal 41, of the transistor 40 is connected to the drain terminal of the initial transistor 20. The transistor 40 is connected in a common-gate manner, wherein the gate terminal 42 is connected to the lower power supply 4. Further, the output, or, in other words, the drain terminal 43 of the second transistor 40 is connected to load 52.

The inputs, i.e. source terminals 31, 41, of the transistors 30, 40 are capacitively coupled by a capacitor 60. The impedance of the capacitor 60 equals $\frac{1}{i*\omega*C}$ with i the imaginary unit, C the capacitance of capacitor 60 and $\omega$ the angular frequency. Thus, depending on the frequency of the signal applied to the nodes of the capacitor 60, the impedance of capacitor 60 alters. For DC signals, the angular frequency equals zero and the capacitor 60 acts as an open circuit. The capacitor 60 does, however, allow AC signals to pass through as a function of the frequency components. The capacitance C determines the frequency characterising the capacitor 60. The capacitance C depends on the sizing of capacitor 60. The dimensions of capacitor 60, e.g. a capacitor area, thereby determine the frequency characterising the capacitive coupling. The capacitor 60 may be dimensioned such that the capacitor 60 behaves as a short circuit at a desired frequency of operation.

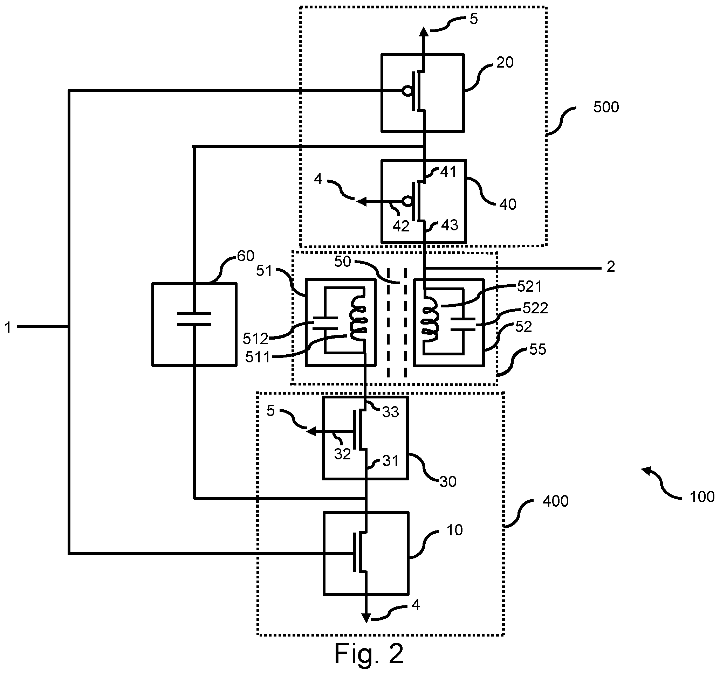

The same reference numerals as in Figure 1 are used to denote the same structural components in Figures 2-7 as further described below.

Figure 2 illustrates an LNA circuitry 100 according to example embodiments. The loads 51, 52 each comprise a capacitor 512, 522 arranged in parallel with an inductor 511, 521. The inductors may be coils that are inductively coupled 50 such that they form a transformer. The coil transformer 511, 521 can advantageously be incorporated in an integrated circuit, IC, having a surface approximately equal to a single coil, thereby providing a compact solution.

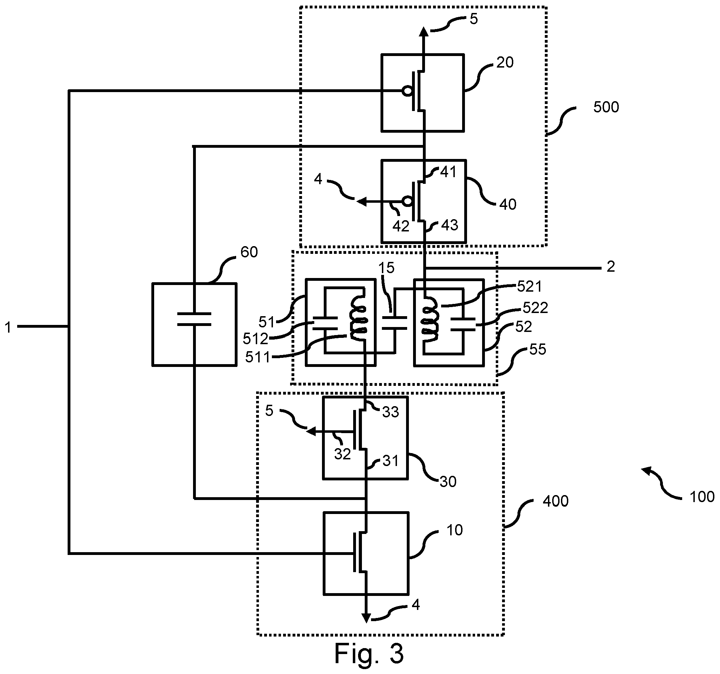

Figure 3 illustrates an LNA circuitry 100 according to example embodiments. As in Figure 2, the loads 51, 52 each comprise a capacitor 512, 522 arranged in parallel with an inductor 511, 521. In Figure 3, the loads 51, 52 are coupled by a capacitor 15.

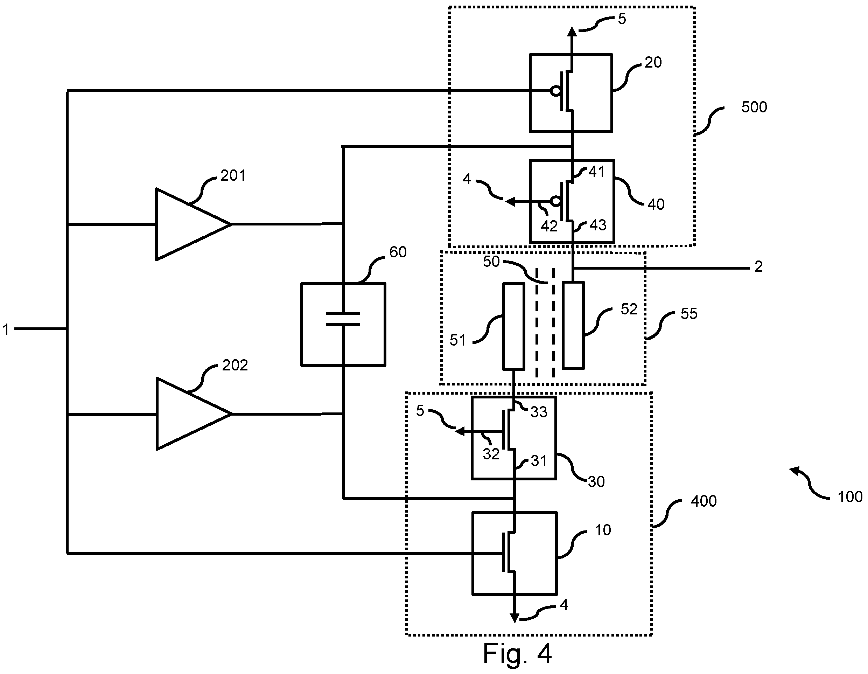

Figure 4 illustrates an LNA circuitry 100 according to example embodiments, wherein two pre-amplifiers 201, 202 are arranged, connected to the cascode amplifier branches. The pre-amplifier 201 is arranged between the input 1 and the input 41 of the transistor 40. Symmetrically, the pre-amplifier 202 is arranged between the input 1 and the input 31 of the transistor 30. As a result, the pre-amplifiers 201, 202 are connected to each other via their outputs by the capacitor 60.

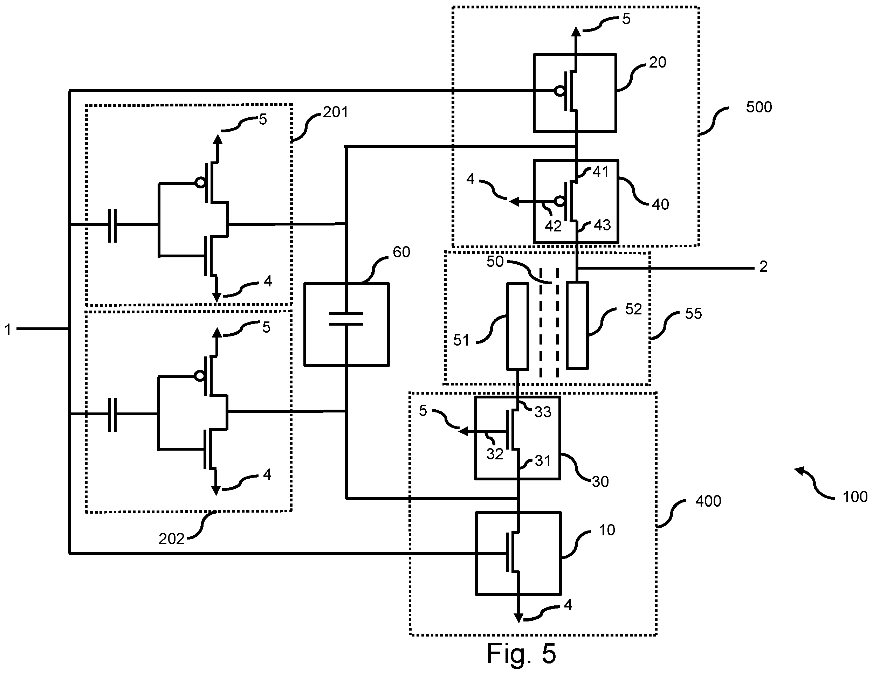

Figure 5 illustrates an LNA circuitry 100 according to example embodiments, wherein the pre-amplifiers 201, 202 are each realised as a CMOS amplifier in series with a capacitor for filtering purposes.

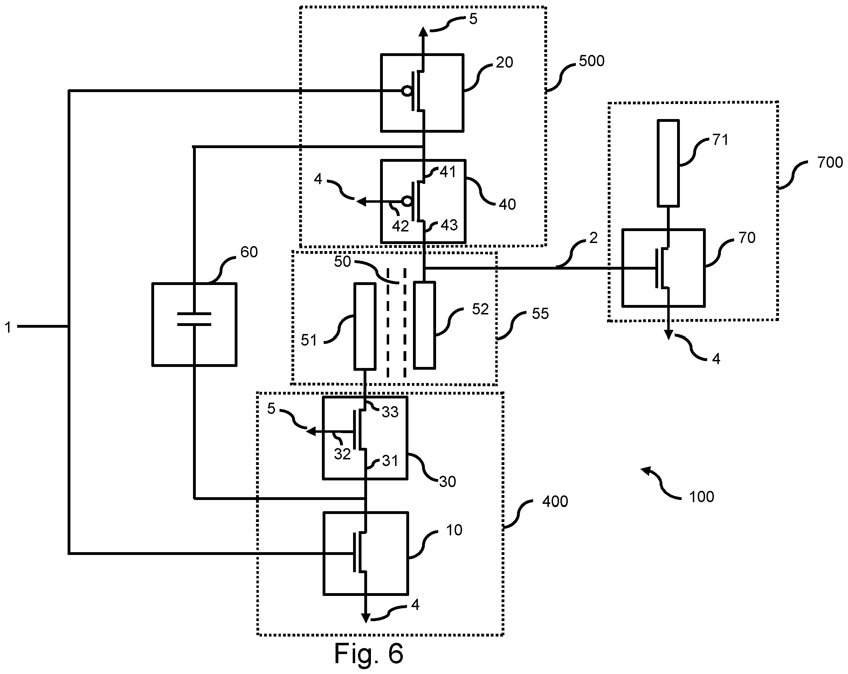

Figure 6 illustrates an LNA circuitry 100 according to example embodiments, wherein the LNA circuitry comprises an output amplifier 700. The output amplifier 700 comprises an output transistor 70 connected to an output load 71 at the drain of transistor 70. The output transistor 70 is arranged in a common-source configuration, wherein its source terminal is connected to the lower power supply 4. In the example of Figure 6, the transistor 70 is an NMOS transistor.

Figure 7 illustrates an LNA circuitry 100 according to example embodiments, wherein the LNA circuitry comprises an output amplifier 700. Contrarily to Figure 6, the transistor 70 is a PMOS transistor and the output 2 is provided at the output of the first cascode amplifier 400.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and I hardware circuit(s) and or processor(s), such as a microprocessor(s) or a portion of a microprocessor(s), that requires software (e.g., firmware) for operation, but the software may not be present when it is not needed for operation." This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

**Claims**

1. A low-noise amplifier, LNA, circuitry (100) for amplifying an input signal at an input (1) to an output signal at an output (2); the circuitry (100) comprising a first cascode amplifier (400) and a second complementary cascode amplifier (500), respectively connected to a first load (51) and a second load (52); wherein the first load (51) and the second load are coupled (50) and wherein the output signal (2) is an output of the first or second cascode amplifier; wherein the first cascode amplifier (400) comprises:

   - a first initial amplification stage (10), connected to the input (1) and to a lower power supply node (4); and
   - a first transistor (30), arranged in a common-gate configuration, in cascode with the first initial amplification stage (10) and connected to the first load (51);
   wherein the second cascode amplifier (500) comprises:

   - a second initial amplification stage (20), connected to the input (1) and to a higher power supply node (5);
   - a second transistor (40), arranged in a common-gate configuration, in cascode with the second initial amplification stage (20) and connected to the second load (52);

   and wherein inputs of the first and second transistors are capacitively coupled (60) such that the first and second transistors are connected at frequencies higher than a frequency characterising the capacitive coupling (60).

**2.** The LNA circuitry according to claim 1, wherein the first and second transistors are configured to operate in a strong saturation region.

**3.** The LNA circuitry (100) according to claim 1 or 2, wherein the first and second transistors (30, 40) respectively comprise a first gate terminal (32) and a second gate terminal (42), wherein the first gate terminal (32) is connected to the higher power supply (5) and wherein the second gate terminal (42) is connected to the lower power supply (4).

**4.** The LNA circuitry (100) according to any one of the preceding claims, wherein the first and second initial amplification stages (10, 20) each comprise a transistor (10, 20), arranged in a common-source configuration.

**5.** The LNA circuitry (100) according to any one of the preceding claims, further comprising a first and a second pre-amplifier configured to pre-amplify the input signal (1) and provide the so obtained pre-amplified input signal to the inputs of the first and second transistors respectively.

**6.** The LNA circuitry (100) according to any one of the preceding claims, wherein the first and second loads (51, 52) each comprise an inductive coil.

**7.** The LNA circuitry (100) according to claim 6, wherein the coils are inductively coupled (50), thereby coupling the first and second loads (51, 52).

**8.** The LNA circuitry (100) according to claim 6, wherein the coils are capacitively coupled (50), thereby coupling the first and second loads (51, 52).

**9.** The LNA circuitry (100) according to any one of the preceding claims, wherein the first and second loads (51, 52) each comprise a capacitor.

**10.** The LNA circuitry (100) according to any one of the preceding claims 9, wherein the first and second loads (51, 52) are capacitively coupled (50).

**11.** The LNA circuitry (100) according to any one of the preceding claims, further comprising a coupling capacitor for providing the capacitive coupling (60).

**12.** The LNA circuitry (100) according to any one of the preceding claims, further comprising an output amplifier (700), wherein the output signal (2) is further applied to the output amplifier (700), thereby cascading the first and second cascode amplifiers (400, 500) with the output amplifier (700).

**13.** The LNA circuitry (100) according to claim 12, wherein the output amplifier (700) comprises an output transistor (70), arranged in a common-source configuration and connected to an output load (71).

**14.** The LNA circuitry (100) according to claim 13, wherein the output signal (2) is the output of the first cascode amplifier (400) and wherein the output transistor (70) is an N-channel metal oxide semiconductor, NMOS, transistor.

**15.** The LNA circuitry (100) according to claim 13, wherein the output signal (2) is the output of the second cascode amplifier (500) and wherein the output transistor (70) is a P-channel metal oxide semiconductor, PMOS, transistor.

Fig. 1

Fig. 2

Fig. 3

Fig. 4

Fig. 5

Fig. 6

Fig. 7

EP 4 557 611 A1

Europäisches
Patentamt

European
Patent Office

Office européen
des brevets

# EUROPEAN SEARCH REPORT

Application Number

**EP 23 21 0737**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/188096 A1 (GRANGER-JONES MARCUS [US]) 15 June 2023 (2023-06-15) | 1-4,6-15 | INV. H03F1/22 H03F1/56 H03F3/195 |
| A | * paragraph [0001] – paragraph [0046]; figures 1-4 * | 5 | |
| A | CN 107 332 522 A (RDA MICROELECTRONICS INC) 7 November 2017 (2017-11-07) * figures 10, 12 * | 1 | |
| A | EP 3 258 597 B1 (INTEL IP CORP [US]) 29 July 2020 (2020-07-29) * paragraph [0032] – paragraph [0036]; figure 2 * | 1 | |

TECHNICAL FIELDS SEARCHED (IPC)

H03F

The present search report has been drawn up for all claims

| Place of search | Date of completion of the search | Examiner |
|---|---|---|
| The Hague | 25 April 2024 | Rafflenbeul, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 21 0737

This annex lists the patent family members relating to the patent documents cited in the above-mentioned European search report.
The members are as contained in the European Patent Office EDP file on
The European Patent Office is in no way liable for these particulars which are merely given for the purpose of information.

25-04-2024

| Patent document cited in search report | Publication date | Patent family member(s) | | Publication date |
|---|---|---|---|---|
| US 2023188096 A1 | 15-06-2023 | NONE | | |
| CN 107332522 A | 07-11-2017 | NONE | | |
| EP 3258597 B1 | 29-07-2020 | CN | 107493078 A | 19-12-2017 |
| | | CN | 116317974 A | 23-06-2023 |
| | | EP | 3258597 A1 | 20-12-2017 |
| | | US | 2017359040 A1 | 14-12-2017 |
| | | US | 2020036349 A1 | 30-01-2020 |

EPO FORM P0459

For more details about this annex : see Official Journal of the European Patent Office, No. 12/82